# EUROPEAN PATENT APPLICATION

(11) **EP 4 635 881 A1**
(43) Date of publication of application: **22.10.2025**
(21) Application number: 25170145.4
(22) Date of filing: 11.04.2025
(51) Int. Cl.: B65G 15/12, B23K 1/00, B23K 1/008, B65G 17/12, B65G 17/42

(54) **TRANSPORT DEVICE AND REFLOW OVEN COMPRISING TRANSPORT DEVICE**

(30) Priority: 15.04.2024 CN 202410451187
(71) Applicant: Illinois Tool Works Inc., Glenview IL 60025 (US)
(72) Inventor: YAN, Shenghu, Glenview, 60025 (US)
(74) Representative: HGF

(57) **Abstract**

The present disclosure discloses a transport device and a reflow oven comprising the same. The transport device includes a first rail device. The first rail device includes a first guide rail and a first conveying belt. The first conveying belt includes a chain and a plurality of support bars, with the plurality of support bars arranged in a length direction, and each of the support bars rotatably connected to the chain, where each of the support bars is rotatable to a first state and a second state, and a distance from the top of the support bar in the second state to the chain is less than that from the top of the support bar in the first state to the chain. The support bars in the first state can support an element to be processed, and the support bars in the second state do not support the element to be processed, thereby reducing the occupied space. With the arrangement of the rotatable support bars, the first conveying belt of the first rail device can always travel in the length direction, enabling a lifting function of the support bars, without the need to move the position of the first conveying belt.

## Description

### TECHNICAL FIELD

The present disclosure relates to the field of reflow ovens, and in particular to a transport device and a reflow oven comprising the transport device.

### BACKGROUND

During the manufacture of printed circuit boards, electronic elements are mounted on the circuit boards generally by using a process known as "reflow soldering". In a typical reflow soldering process, solder paste (e.g., tin paste) is deposited onto selected areas of a circuit board, and wires of one or more electronic elements are inserted into the deposited solder paste. A transport device then carries the circuit board and transports the circuit board to pass through a hearth of the reflow oven. In the hearth of the reflow oven, the solder paste reflows in a heating zone (i.e., being heated to a melting or reflow temperature) and is then cooled in a cooling zone to electrically and mechanically connect the wires of the electronic elements to the circuit board. As used herein, the term "circuit board" includes a substrate assembly of any type of electronic element, for example, including a wafer substrate.

When the circuit board has a large width, the width of the transport device that carries the circuit board needs to be increased accordingly. After being subjected to heating, the circuit board having a large width is susceptible to local sagging and deformation, thereby affecting the yield of the reflow soldering process.

### SUMMARY

In a first aspect, the present disclosure provides a transport device including a first rail device. The first rail device includes a first guide rail and a first conveying belt, where the first guide rail extends in a length direction, the first conveying belt is supported on the first guide rail, and the first conveying belt is configured to travel in the length direction. The first conveying belt includes a chain and a plurality of support bars, with the plurality of support bars arranged in the length direction, and each of the support bars rotatably connected to the chain, where each of the support bars is rotatable to a first state and a second state, and a distance from the top of the support bar in the second state to the chain is less than that from the top of the support bar in the first state to the chain.

According to the first aspect above, an included angle between the support bar in the first state and the first guide rail is greater than that between the support bar in the second state and the first guide rail. The support bar is configured to be switchable reciprocally between the first state and the second state, and the support bar is rotatable from the first state to the second state in a first direction, and rotatable from the second state to the first state in a second direction.

According to the first aspect above, in the first state, the included angle between the support bar and the first guide rail is 90°-100°. In the second state, the included angle between the support bar and the first guide rail is not greater than 45°.

According to the first aspect above, in the first state, the support bar is perpendicular to the first guide rail.

According to the first aspect above, the chain of the first conveying belt is circular and is capable of being driven to travel in a circular manner. The first rail device has an upper support region and a lower return region, and the chain travels forwardly in the upper support region, and travels reversely in the lower return region such that the chain travels in a circular manner. The first conveying belt is configured such that the plurality of support bars in the upper support region are in the first state or in the second state; and the plurality of support bars in the lower return region are in the second state.

According to the first aspect above, each of the support bars includes a bar portion and a rotating shaft, with the rotating shaft extending outwardly from a side of the chain, and the bar portion fitted over the rotating shaft; and the plurality of support bars are rotatably connected to the chain via the respective rotating shafts.

According to the first aspect above, the chain includes a plurality of inner links, a plurality of outer links, and a plurality of pivots, the plurality of inner links and the plurality of outer links are alternately arranged in the length direction, the outer links are disposed on an outer side of adjacent two of the inner links, and the plurality of pivots pass through the corresponding outer links and inner links to hinge them. The plurality of support bars are connected to the corresponding outer links, the rotating shaft of each of the support bars is disposed between adjacent two of the pivots, and each of the support bars is configured to rotate between the adjacent two of the pivots.

According to the first aspect above, each of the support bars further includes a limiting portion, the limiting portion being configured to prevent the support bar from continuing to rotate in the first direction after having reached the second state, and to prevent the support bar from continuing to rotate in the second direction after having reached the first state.

According to the first aspect above, the limiting portion includes a notch and a hook. The notch is provided on the bar portion, where the shape and the dimension of the notch are configured such that the notch is capable of accommodating the pivot when the support bar is in the second state, and that the pivot blocks the support bar from rotating in the first direction. The hook is connected to an end of the bar portion, where the shape and the dimension of the hook are configured such that the hook can hook the pivot when the support bar is in the first state, and that the pivot blocks the support bar from rotating in the second direction.

According to the first aspect above, the first guide rail has an accommodating groove extending in the length direction, the accommodating groove includes an upper chain accommodating groove and a lower chain accommodating groove, the upper chain accommodating groove is disposed in the upper support region and configured to accommodate and support the chain in the upper support region, and the lower chain accommodating groove is disposed in the lower return region and configured to accommodate and support the chain in the lower return region, where the plurality of support bars are connected to a side of the chain away from the accommodating groove. A bottom edge of the first guide rail has a flange protruding toward the chain, and the flange is configured to be capable of abutting against the support bars to keep the support bars in the second state.

According to the first aspect above, the first rail device has a rail entry. The first rail device further includes an entry stop pin, the entry stop pin being disposed at the rail entry, where the entry stop pin is configured to be capable of extending toward the support bar to abut against the bottom of the support bar, so as to drive the support bar to rotate in the second direction, to switch the plurality of support bars located downstream of the entry stop pin from the second state to the first state.

According to the first aspect above, the first rail device further includes a sensing device and a driving device. The sensing device is configured to detect a state of the support bar. The entry stop pin is connected to the driving device. The driving device is configured to, based on the detected state of the support bar, drive the entry stop pin to extend toward or retract from the support bar, so as to change the support bar from the second state to the first state, or keep the support bar in the second state.

According to the first aspect above, the first rail device has a rail exit. The first rail device further includes an exit stop pin, the exit stop pin being disposed at the rail exit, where the exit stop pin is configured to be capable of extending toward the support bar to abut against the top of the support bar, so as to drive the support bar to rotate in the first direction, to switch the plurality of support bars located downstream of the exit stop pin from the first state to the second state.

In a second aspect, the present disclosure provides a reflow oven, including a first rail device, a second rail device and a third rail device. The first rail device is as described in any of the first aspect above. The second rail device includes a second guide rail and a second conveying belt. The third rail device includes a third guide rail and a third conveying belt. The second guide rail and the third guide rail extend in a length direction and are disposed at intervals in a width direction, and the first guide rail is disposed between the second guide rail and the third guide rail in the width direction. When the support bars of the first rail device are in the first state, the tops of the support bars are capable of abutting against a lower surface of an element to be processed, and when the support bars are in the second state, the tops of the support bars are not in contact with the element to be processed. The first conveying belt, the second conveying belt, and the third conveying belt travel synchronously, such that when the support bars are in the first state, the support bars of the first conveying belt, the second conveying belt, and the third conveying belt together carry the element to be processed to pass through the reflow oven.

Other features, advantages and examples of the present disclosure may be elaborated or become apparent by considering the following specific embodiments, accompanying drawings and claims. Furthermore, it should be appreciated that the contents in both the Summary of the Disclosure above and the Detailed Description of Embodiments below are exemplary, and are intended to provide a further explanation, but not to limit the scope of protection of the present disclosure. However, the specific embodiments and specific examples merely indicate preferred embodiments of the present disclosure. For those skilled in the art, various variations and modifications within the spirit and scope of the present disclosure will become apparent by the way of the specific embodiments.

### BRIEF DESCRIPTION OF THE DRAWINGS

Fig. 1 is a schematic diagram of a reflow oven in a length direction according to an embodiment of the present disclosure;
Fig. 2A is a partial perspective view of a transport device in Fig. 1;
Fig. 2B is a side view of the transport device shown in Fig. 2A in a width direction;
Fig. 3A is a side view of a first rail device in Fig. 2A in the length direction;
Fig. 3B is a perspective view of the first rail device in Fig. 3A;
Fig. 4A is an exploded view of a first guide rail and a first conveying belt in Fig. 3A;
Fig. 4B is a side view of the first guide rail and the first conveying belt in Fig. 3A;
Fig. 5A is a perspective view of the first conveying belt, with support bars in Fig. 4A being in a first state;
Fig. 5B is a perspective view of the first conveying belt, with the support bars in Fig. 4A being in a second state;
Fig. 5C is a side view of the first conveying belt shown in Fig. 5A;
Fig. 5D is a side view of the first conveying belt shown in Fig. 5B; and
Fig. 6 is a schematic diagram of a state change process of the support bars of the first rail device shown in Fig. 3A.

### DETAILED DESCRIPTION OF EMBODIMENTS

Various specific embodiments of the present disclosure will be described below with reference to the drawings which form part of this specification. It should be understood that although the terms for indicating directions, such as "front", "rear", "upper", "lower", "left", "right", "top", "bottom", "inner" and "outer", are used in the present disclosure to describe various exemplary structural parts and elements of the present disclosure, these terms are used herein only for ease of illustration and are determined based on the exemplary orientations as shown in the accompanying drawing. Since the arrangements in the embodiments disclosed in the present disclosure may be in various directions, these terms indicating directions are only illustrative and should not be considered as limitations.

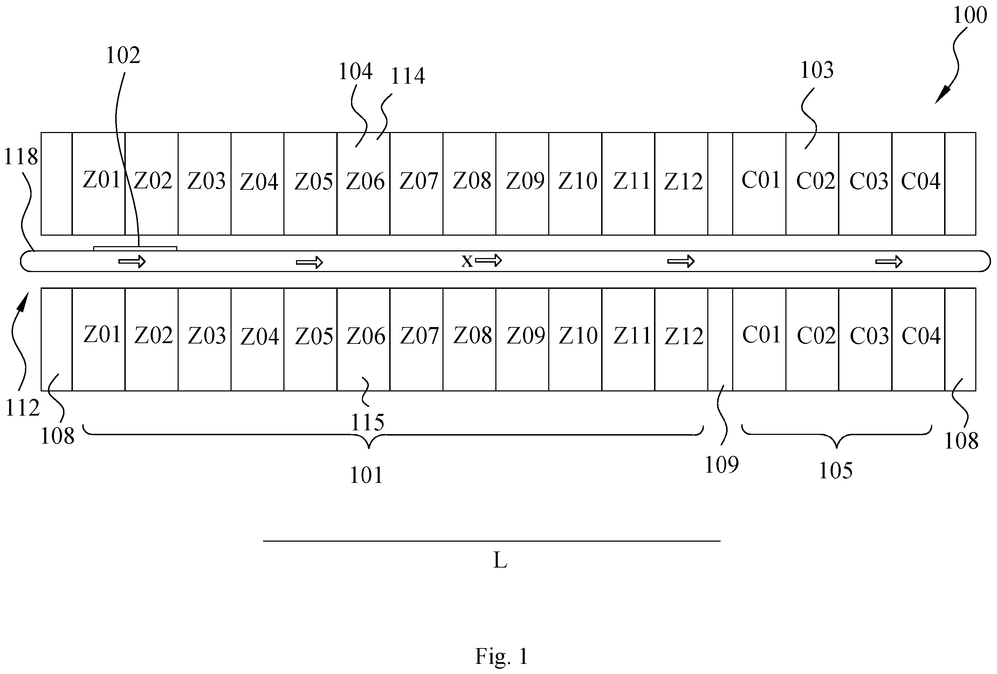

Fig. 1 is a simplified schematic diagram of a reflow oven according to an embodiment of the present disclosure, showing a structure of the reflow oven in a length direction. In this embodiment, for ease of the description of the reflow oven, a housing for shielding a hearth 112 is not shown in Fig. 1.

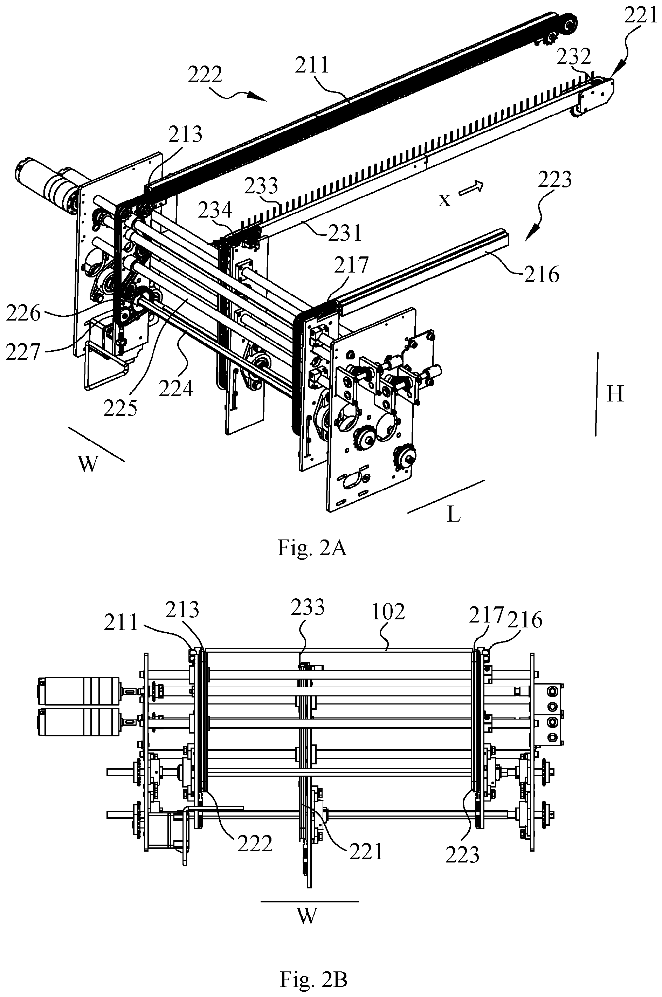

As shown in Fig. 1, a reflow oven 100 includes the hearth 112. The hearth 112 has a length direction L, a width direction W, and a height direction H (as shown in conjunction with Figs. 2A and 2B). The hearth 112 includes a heating zone 101 and a cooling zone 105 in the length direction L. A plurality of processing units with different temperatures are provided in the heating zone 101 and the cooling zone 105, and are arranged side by side in the length direction L of the hearth 112. The reflow oven 100 further includes a transport device 118. The transport device 118 runs through the hearth 112 in the length direction L of the hearth 112, and is configured to carry an element to be processed 102, to feed the element to be processed 102 from a left end of the hearth 112 into the hearth 112, to cause the element to pass through the heating zone 101 and the cooling zone 105 of the hearth 112 sequentially in a transport direction x to treat the element, and then to output the treated element 102 from a right end of the hearth 112. In this embodiment, the transport direction x is arranged along the length direction L. The hearth 112 includes an upper hearth 114 and a lower hearth 115 disposed opposite each other in the height direction. Houses of the upper hearth 114 and the lower hearth 115 are hermetically connected together. A space is provided between the upper hearth 114 and the lower hearth 115 such that the transport device 118 is disposed in the space between the upper hearth 114 and the lower hearth 115.

Specifically, in this embodiment, the element to be processed 102 is a circuit board. After being treated in the reflow oven, electronic elements on the circuit board are soldered to solder joints on the circuit board. The heating zone 101 includes twelve heating units 104. Each of the heating units 104 is provided with a heating device for heating gas in the heating unit 104 independently. The twelve heating units 104 are heating units Z01-Z12, respectively. The heating units Z01-Z12 are connected in sequence, and the temperature of gas inside the heating units gradually increases from Z01 to Z12. "Connected in sequence" means that these heating units are sequentially arranged in numerical order. For example, the heating units Z10 and Z12 are located on two sides of the heating unit Z11, and the heating unit Z10 is located between the heating unit Z09 and the heating unit Z11. The temperature of gas in the heating unit Z10 is higher than the temperature of gas in the heating unit Z09 but lower than the temperature of gas in the heating unit Z11. In the heating units Z01-Z09, the circuit board is heated, and part of a soldering flux in a solder paste dispensed on the circuit board is vaporized. The temperature of gas in the heating units Z10-Z12 is higher than the temperature of gas in the heating units Z01-Z09, and the solder paste is completely melted in the heating units Z10-Z12. The heating units Z10-Z12 belong to zones in which even VOCs (e.g., rosin and resin in the soldering flux) with higher temperature will be vaporized.

The cooling zone 105 includes four cooling units 103. Each of the cooling units 103 is provided with a cooling device for cooling gas in the cooling unit 103 independently. The four cooling units 103 are cooling units C01-C04, respectively. The cooling units C01-C04 are also sequentially arranged in numerical order, and the temperature of gas inside the cooling units gradually decreases from C01-C04. After the circuit board is transported from the heating unit Z12 into the cooling zone 105, the solder paste is cooled to be solidified into solder joints in a soldering region of the circuit board, thereby connecting an electronic element to the circuit board. It is worth noting that the number of processing units in the heating zone 101 and the cooling zone 105 of the reflow oven may be changed depending on products to be soldered and different soldering processes, and is not only limited to the embodiment shown in Fig. 1.

A isolating and discharging zone 109 is provided in a connection region between the heating unit Z12 and the cooling unit C01. Gas may be drawn or discharged from the hearth 112 through the isolating and discharging zone 109. The gas drawn from the isolating and discharging zone 109 is cooled and filtered, and then can be delivered back to a processing unit with a lower temperature in the hearth 112, thereby preventing or reducing the entry of the gas containing volatile contaminants from the heating zone 101 into the cooling zone 105. Furthermore, by drawing or discharging the gas from the hearth 112, the isolating and discharging zone 109 can also serve as a temperature isolating region for isolating the heating unit Z12 in the high-temperature heating zone 101 from the low-temperature cooling zone 105.

The reflow oven further includes a pair of isolating tanks 108. The pair of isolating tanks 108 are disposed at left and right ends of the hearth 112, respectively, i.e., on an outer side of the heating zone 101 and an outer side of the cooling zone 105, respectively. When using an inert gas (e.g. nitrogen gas) as a working gas in the reflow oven, the pair of isolating tanks 108 is configured to prevent the heating zone 101 and the cooling zone 105 in the hearth 112 from communicating with an external environment to prevent the air in the external environment from affecting the soldering quality.

Figs. 2A and 2B show a specific structure of the transport device 118, for describing a positional relationship of a first rail device, a second rail device and a third rail device. Fig. 2A shows a perspective view of the transport device 118 from the front side, and Fig. 2B shows a left side view of Fig. 2A. As shown in Figs. 2A and 2B, the transport device 118 includes a first rail device 221, a second rail device 222 and a third rail device 223. In the width direction W, the first rail device 221 is disposed between the second rail device 222 and the third rail device 223. In this way, when edges, in the width direction, of the element to be processed 102 are supported on the second rail device 222 and the third rail device 223, the first rail device 221 can support the middle area of the element to be processed 102, thereby preventing the middle area from sagging and deforming when the width of the element to be processed 102 is too large.

Specifically, the first rail device 221 includes a first guide rail 231 and a first conveying belt 232, the first conveying belt 232 being supported on the first guide rail 231. The second rail device 222 includes a second guide rail 211 and a second conveying belt 213, the second conveying belt 213 being supported on the second guide rail 211. The third rail device 223 includes a third guide rail 216 and a third conveying belt 217, the third conveying belt 217 being supported on the third guide rail 216. The first guide rail 231, the second guide rail 211 and the third guide rail 216 all extend in the length direction L. The first guide rail 231 is disposed between the second guide rail 211 and the third guide rail 216. The edges, in the width direction W, of the element to be processed 102 are supported on the second conveying belt 213 and the third conveying belt 217, respectively. The middle area, in the width direction W, of the element to be processed 102 is supported on the first conveying belt 232.

The transport device 118 further includes a driving mechanism. The first conveying belt 232, the second conveying belt 213 and the third conveying belt 217 are connected by means of the driving mechanism, so that the first conveying belt 232, the second conveying belt 213 and the third conveying belt 217 travel synchronously in the transport direction x and jointly carry the element to be processed 102 to pass through the reflow oven 100. In this embodiment, the driving mechanism is disposed on an entry side of the reflow oven 100, and the driving mechanism includes a driving shaft 224 and a plurality of drive gears 226. The first conveying belt 232, the second conveying belt 213, and the third conveying belt 217 include chain-type drive belts. More specifically, the driving shaft 224 extends in the width direction W and is connected between the first rail device 221, the second rail device 222 and the third rail device 223. The driving shaft 224 is driven to rotate by means of a driving device such as an electric motor. The plurality of drive gears 226 are connected to the driving shaft 224 to rotate as the driving shaft 224 rotates. Moreover, the plurality of drive gears 226 are connected to the first conveying belt 232, the second conveying belt 213, and the third conveying belt 217 by gear meshing, so that the first conveying belt 232, the second conveying belt 213, and the third conveying belt 217 can be driven to travel synchronously by the rotation of the plurality of drive gears 226. The transport device 118 further includes a plurality of tension pulleys 227 and a plurality of support shafts 225. The plurality of tension pulleys 227 are connected to the first conveying belt 232, the second conveying belt 213 and the third conveying belt 217 to adjust the tension force of the respective conveying belts. The plurality of support shafts 225 and the driving shaft 224 are arranged in parallel, and are connected to the first rail device 221, the second rail device 222 and the third rail device 223. In this embodiment, the second guide rail 211 is a fixed guide rail and the third guide rail 216 is a movable guide rail. The third guide rail 216 can move along the driving shaft 224 and the plurality of support shafts 225 to move closer to or away from the second guide rail 211, and in turn, the third conveying belt 217 moves closer to or away from the second conveying belt 213 along with the third guide rail 216. In this way, the transport device 118 can adjust a distance between the second guide rail 211 and the third guide rail 216 according to the dimensions of the element to be processed 102, so that the edges of the element to be processed 102 remain supported on the second conveying belt 213 and the third conveying belt 217.

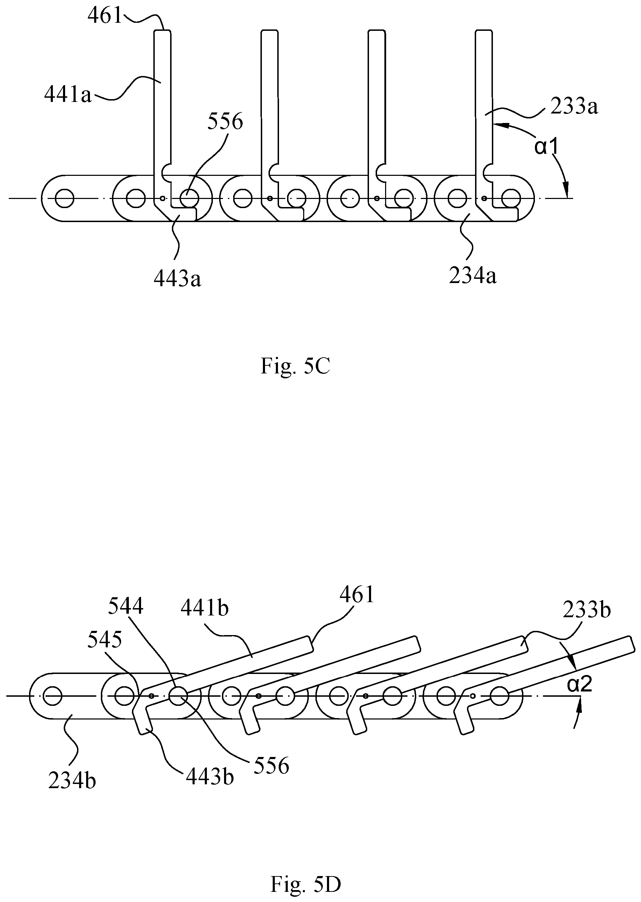

More specifically, the first conveying belt 232 includes a chain 234 and a plurality of support bars 233. The plurality of support bars 233 are arranged in the length direction L. Each of the support bars 233 is rotatably connected to the chain 234 to travel as the chain 234 travels. Each of the support bars 233 has a first state or a second state, and the support bar 233 can be switched reciprocally between the first state and the second state. A distance from the top of the support bar 233 in the second state to the chain 234 is less than that from the top of the support bar 233 in the first state to the chain 234. In this way, when the support bars 233 are in the first state, the tops of the support bars 233 can abut against a lower surface of the element to be processed 102. When the support bars 233 are in the second state, the height of the tops of the support bars 233 is lowered, so that the tops of the support bars 233 are not in contact with the lower surface of the element to be processed 102, and the space occupied by the support bars in the height direction is reduced. In some embodiments, an included angle between the support bar 233 in the first state and the first guide rail 231 is greater than that between the support bar 233 in the second state and the first guide rail 231. In some embodiments, an included angle α1 between the support bar 233 in the first state and the first guide rail 231 is 90°-100°, and an included angle α2 between the support bar 233 in the second state and the first guide rail 231 is not greater than 45° (see Figs. 5C and 5D). The included angle between the support bar and the first guide rail herein is an included angle between the support bar 233 and the first guide rail 231 on the right side of the support bar, i.e., on the side close to the support bar 233 in the second state. In such angle ranges, the top of the support bar 233 in the first state can more stably support the element to be processed 102, and the support bar 233 in the second state can be not in contact with the element to be processed 102, thereby reducing the occupied space. In this embodiment, the support bar 233 in the first state is substantially perpendicular to the first guide rail 231 (i.e., substantially at 90°). When the element to be processed 102 has a large width, the support bar 233 is allowed to be in the first state to support the middle area of the element to be processed 102 and to prevent the middle area of the element to be processed 102 from sagging and deforming. When the support bar 233 is not required for supporting the element to be processed 102, for example, when the element to be processed 102 has a small width or the support bar 233 leaves the element to be processed 102, the support bar 233 is allowed to be in the second state such that the support bar 233 is hidden and the space occupied by the support bar 233 is reduced. A more detailed structure of the first rail device 221 will be described in detail below.

It will be appreciated by those skilled in the art that the driving mechanism may be configured as other structures, as long as it can drive the first conveying belt 232, the second conveying belt 213 and the third conveying belt 217 to travel synchronously. The second rail device 222 and the third rail device 223 may be configured as any structures known in the art.

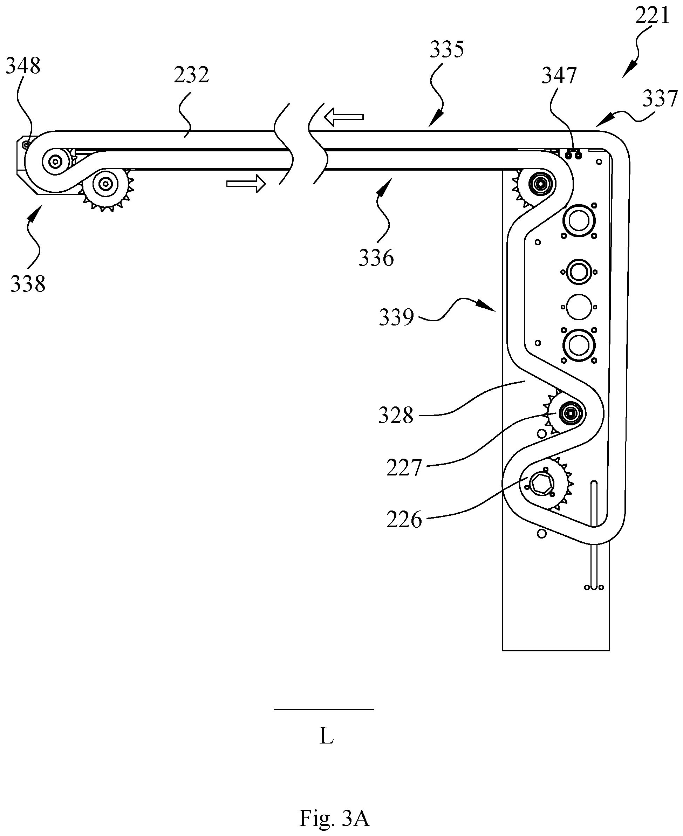

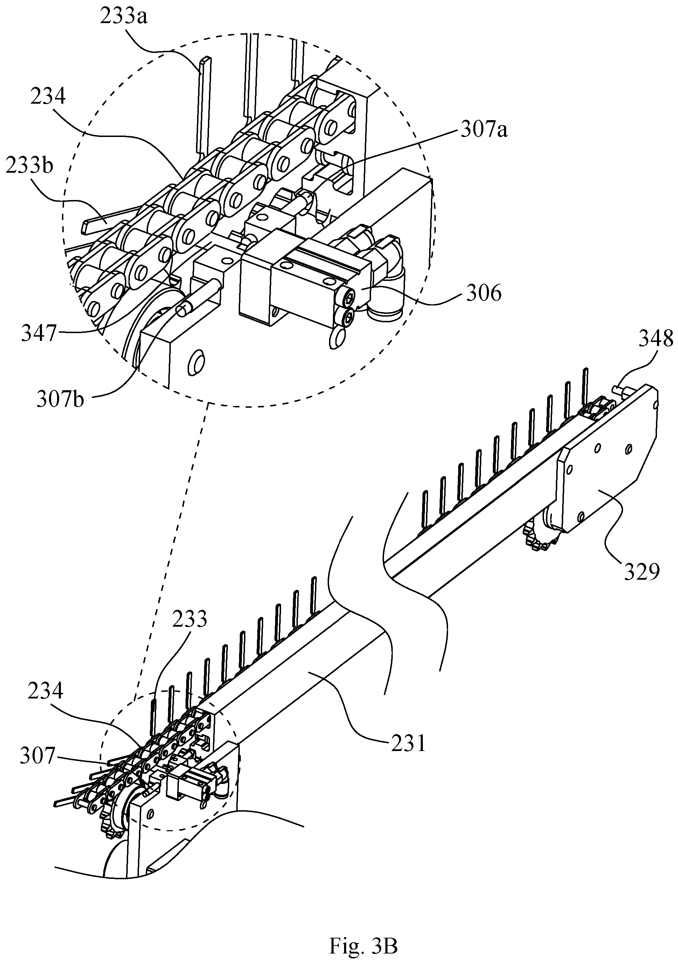

Figs. 3A and 3B show a more detailed structure of the first rail device 221. Fig. 3A shows a side view of the first rail device 221 in the length direction L (i.e., a left view of the first rail device 221 in Fig. 2A), and Fig. 3B shows a partially enlarged perspective view of the first rail device 221. In Fig. 3A, in order to more clearly illustrate a path of travel of the first conveying belt 232, the specific structure of the first conveying belt 232 is not shown, but the first conveying belt 232 is represented with a hollow strip.

As shown in Figs. 3A and 3B, the chain 234 of the first conveying belt 232 is circular to enable the first conveying belt 232 to travel in a circular manner. The first rail device 221 has an upper support region 335 and a lower return region 336, and a rail entry 337 and a rail exit 338. The chain 234 travels forwardly in the upper support region 335 from the rail entry 337 to the rail exit 338 (i.e., traveling from right to left in Fig. 3A), and travels reversely in the lower return region 336 from the rail exit 338 to the rail entry 337 (i.e., traveling from left to right in Fig. 3A) such that the chain 234 can be driven to travel in a circular manner. In this embodiment, the first rail device 221 further has a vertical region 339. The vertical region 339 is disposed at the rail entry 337 and connected between the upper support region 335 and the lower return region 336 such that the chain 234, after passing through the lower return region 336 to return to the rail entry 337, passes through the vertical region 339 before returning to the upper support region 335. The drive gears 226 and the tension pulleys 227 are disposed in the vertical region 339. It will be appreciated by those skilled in the art that, depending on the actual situation, it is also possible that no vertical region 339 is provided, the upper support region 335 and the lower return region 336 are connected directly to each other, and the drive gears and the tension pulleys are disposed at other positions accordingly.

When the first conveying belt 232 is in the upper support region 335, the support bars 233 may be in the first state to support the element to be processed 102, or may be in the second state to leave the element to be processed 102 and in this state the support bars 233 are hidden. When the first conveying belt 232 is in the lower return region 336, the support bars 233 are in the second state to hide the support bars 233. In the present disclosure, the first conveying belt 232 needs to have the function of supporting the element to be processed 102 only when it is in the upper support region 335, and is not in contact with the element to be processed 102 when it is in the lower return region 336. Accordingly, when the first conveying belt 232 is in the lower return region 336, the support bars 233 being in the second state can save the space that the first conveying belt 232 needs to occupy. When the first conveying belt 232 is in the upper support region 335, the support bars 233 may be in the first state or the second state according to specific requirements, such as the dimensional requirements of the element to be processed 102.

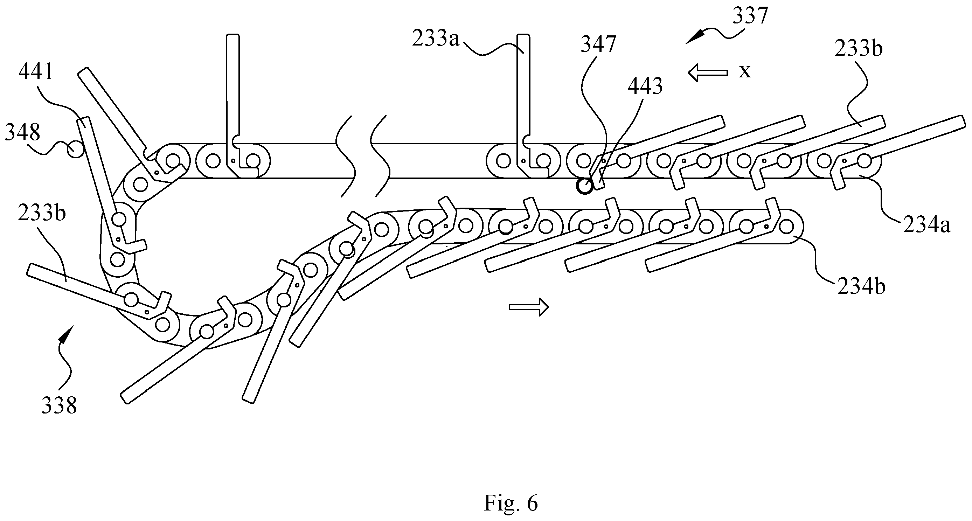

In this embodiment, the first rail device 221 further includes an entry stop pin 347 and an exit stop pin 348. The entry stop pin 347 and the exit stop pin 348 are configured to drive the support bars 233 to rotate, to change the state of the support bars 233 located downstream of the entry stop pin and the exit stop pin in a direction of travel of the first conveying belt 232. Specifically, the first rail device 221 further includes an entry support plate 328 and an exit support plate 329. The entry support plate 328 is disposed at the rail entry 337 and located on a side of the first guide rail 231 in the width direction W (e.g., the right side in Fig. 3B). Moreover, the entry stop pin 347 is connected to the entry support plate 328 and extends in a direction from the entry support plate 328 to the support bars 233. The exit support plate 329 is disposed at the rail exit 338 and is located on a side of the first guide rail 231 in the width direction W (e.g., the right side in Fig. 3B). Moreover, the exit stop pin 348 is connected to the exit support plate 329 and extends in a direction from the exit support plate 329 to the support bars 233. During the travel of the first conveying belt 232, when the support bars 233 abut against the entry stop pin 347 and the exit stop pin 348, the entry stop pin 347 and the exit stop pin 348 can drive the support bars 233 to rotate, thereby changing the state of the support bars 233. In this embodiment, the exit stop pin 348 is configured to make the support bars 233 rotate from the first state to the second state, ensuring that the support bars 233 located in the lower return region 336 are in the second state. The entry stop pin 347 is configured to make the support bars 233 rotate from the second state to the first state. A more specific state change process of the support bars 233 will be described in detail with reference to Fig. 6.

In this embodiment, the first rail device 221 further includes a sensing device 307 and a driving device 306. The sensing device 307 and the driving device 306 are also disposed at the rail entry 337 and are connected to the entry support plate 328. The sensing device 307 is configured to detect the state of the support bars 233, for example, to detect whether the support bars 233 are in the first state or the second state. In some embodiments, the sensing device 307 is a position sensor. The driving device 306 is connected to the entry stop pin 347 to drive the entry stop pin 347 to extend toward or retract from the support bar 233, for example, in the width direction W, based on results of the sensing device 307. When the entry stop pin 347 extends toward the support bar 233, the entry stop pin 347 can drive the support bar 233 to rotate from the second state to the first state. When the entry stop pin 347 retracts, the entry stop pin 347 is not in contact with the support bar 233, so that the state of the support bar 233 is not changed and the support bar 233 is kept in the second state. In some embodiments, the driving device 306 is a pneumatic cylinder. The sensing device 307 includes a sensor 307a and a sensor 307b disposed in the length direction L. It will be appreciated by those skilled in the art that the sensing device is not necessary and that in some embodiments, it is also possible that no sensing device is provided.

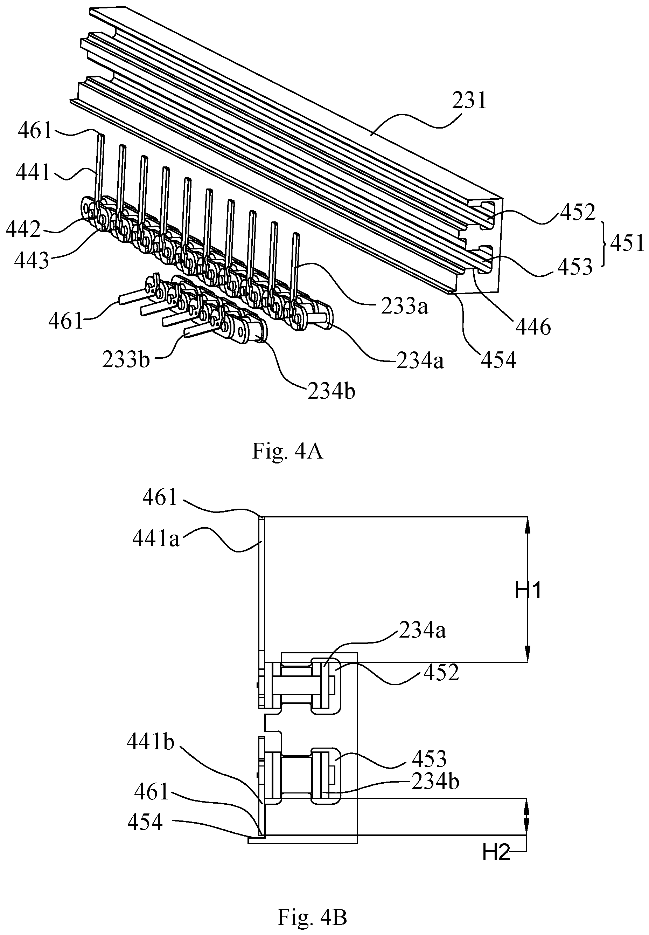

Figs. 4A and 4B show a cooperating structure of the first guide rail 231 and the first conveying belt 232. Fig. 4A is an exploded view of the first guide rail 231 and the first conveying belt 232, and Fig. 4B is a side view of the first guide rail 231 and the first conveying belt 232 in the width direction W. Moreover, in order to illustrate more clearly a partial structure of the first conveying belt 232, only some of the support bars 233 and part of the chain are shown. Hereinafter, a support bar in the first state is represented by a support bar 233a, and a support bar in the second state is represented by a support bar 233b. Moreover, a chain in the upper support region 335 is represented by a chain 234a, and a chain in the lower return region 336 is represented by a chain 234b.

As shown in Figs. 4A and 4B, the first guide rail 231 has an accommodating groove 451. The accommodating groove 451 extends in the length direction L, and is recessed to the right in the width direction W from the left side of the first guide rail 231. The accommodating groove 451 is configured to accommodate the chain 234 of the first conveying belt 232 to support the chain 234 travelling in an extension direction of the accommodating groove 451, i.e., in the length direction L. Specifically, the accommodating groove 451 includes an upper chain accommodating groove 452 and a lower chain accommodating groove 453. The upper chain accommodating groove 452 is provided in the upper support region 335 and configured to accommodate and support the chain 234a in the upper support region 335. The lower chain accommodating groove 453 is provided in the lower return region 336 and configured to accommodate and support the chain 234b in the lower return region 336. The upper chain accommodating groove 452 and the lower chain accommodating groove 453 are substantially the same in shape and structure, and are both shaped to have opposed protrusions 446 at the top and bottom to match the shape of the chain 234, thereby accommodating the chain 234 while restricting the movement of the chain 234 in the width direction W. A bottom edge of the first guide rail 231 further has a flange 454. The flange 454 also extends in the length direction L, and protrudes outwardly from the bottom edge of the first guide rail 231 in the width direction W. The flange 454 is configured to abut against the support bars 233 in the second state that are located in the lower return region 336, to keep the support bars 233 that are located in the lower return region 336 in the second state.

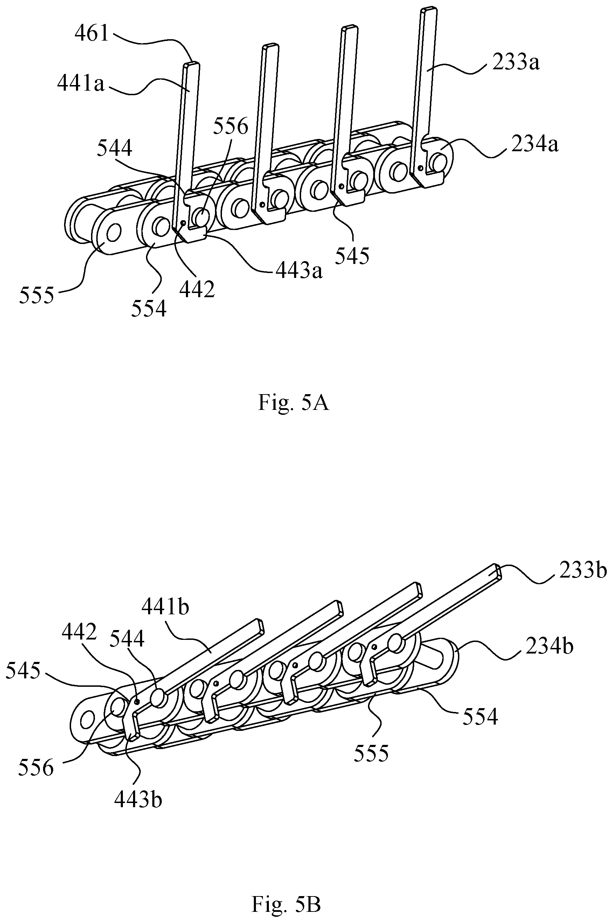

Since the support bars 233 are connected to the left side of the chain 234, i.e., a side away from the accommodating groove 451, the support bars 233 are located outside the accommodating groove 451 when the chain 234 is accommodated in the accommodating groove 451. Each of the support bars 233 is substantially in L-shape with a right-angled corner and includes a bar portion 441, a rotating shaft 442 and a hook 443 (see Figs. 5A to 5D for further details). Each of the support bars 233 is rotatably connected to the chain 234 via the rotating shaft 442. As an example, the rotating shaft 442 extends outwardly from the left side of the chain 234, and the bar portion 441 is disposed over the rotating shaft 442, so that the bar portion 441 can rotate about the rotating shaft 442. The rotating shaft 442 is disposed at the bottom of the bar portion 441, such that the rotation coverage range of the hook 443 is smaller than the rotation coverage range of the bar portion 441 during rotation of the support bar 233. By reducing the rotation coverage range of the hook 443 during rotation of the support bar 233, there is no need to set a large distance between the chain 234a and the chain 234b to avoid interfering with the rotation of the support bar 233. Therefore, such a structure of the support bar 233 can reduce the dimension of the first rail device 221 in the height direction.

A top end 461 of the bar portion 441 is substantially planar in shape for abutting against the element to be processed 102. The hook 443 is connected to a bottom end of the bar portion 441, and the hook 443 is disposed substantially perpendicular to the bar portion 441. When the support bar 233 is in the first state, the bar portion 441 is vertical, the hook 443 is horizontal, and a lower surface of the hook 443 is substantially flush with a lower surface of the chain 234.

In this way, the chain 234a of the first conveying belt 232 located in the upper support region 335 is accommodated and supported in the upper chain accommodating groove 452 of the first guide rail 231 and travels in the length direction L from rear to front. The support bar 233a of the first conveying belt 232 located in the upper support region 335 is in the first state, with a bar portion 441a extending upwardly and vertically above the chain 234a to enable the top end 461 of the bar portion 441a to abut against the lower surface of the element to be processed 102. When the hook 443 is horizontal, the hook 443 does not extend beyond a lower surface of the chain 234a in the height direction.

The chain 234b of the first conveying belt 232 located in the lower return region 336 is accommodated and supported in the lower chain accommodating groove 453 of the first guide rail 231 and travels in the length direction L from front to rear. The support bar 233b of the first conveying belt 232 located in the lower return region 336 is in the second state, with a bar portion 441b extending downwardly and obliquely below the chain 234b, in which case the top end 461 of the bar portion 441b is at the lowest point of the first conveying belt 232 and abuts against the flange 454. The hook 443 is tilted upwardly above an upper surface of the chain 234b.

A distance H1 from the support bar 233a in the first state to the chain 234a is greater than a distance H2 from the support bar 233b in the second state to the chain 234b, and accordingly, setting the support bar 233b, which is not required for carrying the element to be processed 102, to be in the second state can reduce the total space occupied by the first rail device 221 in terms of height.

Figs. 5A to 5D show a more detailed structure of the first conveying belt 232. Figs. 5A and 5C show a structure of the first conveying belt 232, with the support bars 233a in Fig. 4A being in the first state. Figs. 5B and 5D show the structure of the first conveying belt 232, with the support bars 233b in Fig. 4A being in the second state. For ease of viewing, only part of a circulation unit of the first conveying belt 232 is shown in Figs. 5A to 5D.

As shown in Figs. 5A to 5D, the chain 234a and the chain 234b have the same structure to enable the first conveying belt 232 to travel in a circular manner. The chain 234a and the chain 234b each include a plurality of inner links 555, a plurality of outer links 554, and a plurality of pivots 556. The inner links 555 and the outer links 554 are arranged alternately in the length direction L. Each of the outer links 554 is disposed on an outer side of adjacent two inner links 555, and is hinged to the adjacent two inner links 555. In this embodiment, the plurality of pivots 556 pass through the corresponding outer links 554 and inner links 555 to hinge them.

In this embodiment, the plurality of support bars 233 are arranged in correspondence with the plurality of outer links 554, and each of the support bars 233 is connected to an outer side of the corresponding outer link 554 via the rotating shaft 442. Each rotating shaft 442 is disposed between two adjacent pivots 556 to limit the rotation range of the support bar 233 substantially between the two adjacent pivots 556. As an example, the rotating shaft 442 is disposed substantially at the center of the outer link 554.

To further limit the rotation range of the support bar 233, the support bar 233 and the chain 234 are provided with limiting structures that cooperate with each other to limit the support bar 233 to rotate reciprocally between the first state and the second state. In this embodiment, the support bar 233 is further provided with a limiting portion. The limiting portion cooperates with the pivot 556 of the chain 234 to limit the direction of rotation and the angle of rotation of the support bar 233. For example, the support bar 233a in the first state is allowed to rotate only in a first direction (i.e., a clockwise direction in Figs. 5C and 5D) to the second state, and the support bar 233b in the second state is allowed to rotate only in a second direction (i.e., a counterclockwise direction in Figs. 5C and 5D) to the first state. As a specific example, the limiting portion includes a notch 544 provided in the bar portion 441 and the hook 443 connected to the bottom of the bar portion 441. The notch 544 is provided on the right side of the bar portion 441 and close to the bottom thereof, and has the shape and the dimension configured to match those of the pivot 556, so that the notch 544 on the bar portion 441b of the support bar 233b in the second state can accommodate the pivot 556 and block the rotation of the support bar 233b in the first direction, but not block the rotation of the support bar 233b in the second direction. The hook 443 is disposed at the bottom end of the bar portion 441 and extends to the right, and has the shape and the dimension configured to match those of the pivot 556, so that the hook 443 of the support bar 233a in the first state can hook the pivot 556 and block the rotation of the support bar 233a in the second direction, but not block the rotation of the support bar 233a in the first direction. In this embodiment, the support bar 233 further include an inclined surface 545. The inclined surface 545 is provided on a side of the bottom of the bar portion 441 opposite to the hook 443, thereby providing clearance for the pivot 556 on the left side during rotation of the support bar 233 in the first direction from the first state.

It will be appreciated by those skilled in the art that the direction of rotation of the support bar 233 is related to the direction of travel of the chain 234. Based on the desired direction of rotation of the support bar 233, positions of the notch 544 and the hook 443 may be set accordingly. Moreover, the limiting structures may also be configured as other structures according to requirements.

Fig. 6 is a schematic diagram showing a state change process of the support bars of the first rail device, for illustrating the process in which the entry stop pin 347 and the exit stop pin 348 drive the support bars 233 to rotate. As shown in Fig. 6, at the rail entry 337, the entry stop pin 347 is disposed below the chain 234a at the rail entry 337 and close to the chain 234a. When the driving device 306 controls the entry stop pin 347 to extend, since the hook 443 of the support bar 233b is lower than the lower surface of the chain 234, the entry stop pin 347 is allowed to be in contact with the hook 443 of the support bar 233b and to block the hook 443 of the support bar 233b in the direction of travel of the support bar 233b so as to drive the support bar 233b to rotate about the second direction (i.e., the counterclockwise direction) until the hook 443 is flush with the lower surface of the chain 234a, at this time the support bar 233 is rotated to the first state. During travel of the support bar 233b in the second state from right to left in the transport direction x, the entry stop pin 347 blocks the respective support bars 233b in sequence and drives the respective support bars 233b that pass through the entry stop pin 347 to rotate to the first state. When the driving device 306 drives the entry stop pin 347 to retract, the entry stop pin 347 does not block the hook 443 of the support bar 233b, thereby keeping the respective support bars 233b that pass through the entry stop pin 347 in the second state.

At the rail exit 337, the exit stop pin 348 is disposed at the rail exit 337 and is located approximately on the left-most side of the chain 234a, i.e., near the connection between the chain 234a and the chain 234b. The exit stop pin 348 is configured to be in contact with the bar portion 441 of the support bar 233a and block the bar portion 441 of the support bar 233a in the direction of travel of the support bar 233a so as to drive the support bar 233a to rotate in the first direction (i.e., the clockwise direction) until the notch 544 of the bar portion 441 abuts against the pivot 556, at this time the support bar 233 is rotated to the second state. During the travel of the support bar 233a in the first state from the upper support region 335 to the lower return region 336, the exit stop pin 348 blocks the respective support bars 233a in sequence and drives the respective support bars 233a that pass through the exit stop pin 348 to rotate to the second state. In this embodiment, the exit stop pin 348 is disposed at the connection between the chain 234a and the chain 234b and is located on the left side of the chain 234a, so that the ability of the support bar 233a in the first state to support the element to be processed 102 will not be compromised, and the support bars 233 that are not required for supporting the element to be processed 102 can be retracted to the second state as soon as possible, thereby saving the space occupied by the support bars 233 and avoiding the possible interference between the support bars 233 and other gears.

Those skilled in the art may arrange the entry stop pin and the exit stop pin at other positions of the rail entry and the rail exit according to specific requirements, as long as the support bars can be driven to rotate in a corresponding direction.

The transport device of the reflow oven in the present disclosure includes three rail devices arranged side by side in the width direction, which can provide a good support to the element to be processed and prevent the middle area of the element to be processed from sagging and deforming when said element is subjected to heating even during the processing of the element with a large width.

The first rail device of the present disclosure includes the chain and the support bars rotatably connected to the chain. The support bars may be rotated to the first state or the second state according to the specific requirements. The support bars in the first state can support an element to be processed, and the support bars in the second state do not support the element to be processed, thereby reducing the occupied space. With the arrangement of the rotatable support bars, the first conveying belt of the first rail device can always travel in the length direction, enabling a lifting function of the support bars, without the need to change the position of the first conveying belt.

When the chain of the first rail device of the present disclosure runs to the lower return region, the support bars can rotate to the second state, thereby saving the space occupied by the first rail device in the height direction. In addition, the bottom edge of the first guide rail of the first rail device of the present disclosure is provided with the flange, ensuring that the support bars in the lower return region are in the second state, thereby improving the reliability of the lifting function of the support bars.

Moreover, the first rail device of the present disclosure is provided with the entry stop pin and the exit stop pin to drive the support bars to switch between the first state and the second state. The first rail device further includes the driving device for controlling the extension or retraction of the entry stop pin, so that the support bar that passes through the entry stop pin may be in the first state or the second state, and the support bar that passes through the exit stop pin is in the second state.

Furthermore, according to the present disclosure, the support bars being switched between the first state and the second state enables the first conveying belt of the first rail device to have a smaller reverse bending radius as compared to a conveying belt which keeps the support bars in the first state, thereby reducing the dimensions of the drive gears and the tension pulleys, and further reducing the space occupied by the first rail device.

Although the present disclosure is described with reference to the examples of the embodiments outlined above, various alternatives, modifications, variations, improvements and/or substantial equivalents, which are known or can be anticipated at present or to be anticipated before long, may be obvious to those of at least ordinary skill in the art. **In** addition, the technical effects and/or technical problems described in this specification are exemplary rather than limiting. Therefore, the present disclosure in this specification may be used to solve other technical problems and may have other technical effects. Accordingly, the examples of the embodiments of the present disclosure as set forth above are intended to be illustrative rather than limiting. Various changes may be made without departing from the spirit or scope of the present disclosure. Therefore, the present disclosure is intended to embrace all known or earlier disclosed alternatives, modifications, variations, improvements and/or substantial equivalents.

## Claims

1. A transport device, comprising:
a first rail device comprising a first guide rail and a first conveying belt, wherein the first guide rail extends in a length direction, the first conveying belt is supported on the first guide rail, and the first conveying belt is configured to travel in the length direction; and
the first conveying belt comprises a chain and a plurality of support bars, with the plurality of support bars arranged in the length direction, and each of the support bars rotatably connected to the chain, wherein each of the support bars is rotatable to a first state and a second state, wherein a distance from the top of the support bar in the second state to the chain is less than that from the top of the support bar in the first state to the chain.

2. The transport device according to claim 1, wherein
an included angle between the support bar in the first state and the first guide rail is greater than that between the support bar in the second state and the first guide rail;
wherein the support bar is configured to be switchable reciprocally between the first state and the second state, and the support bar is rotatable from the first state to the second state in a first direction, and rotatable from the second state to the first state in a second direction.

3. The transport device according to claim 2, wherein
in the first state, the included angle between the support bar and the first guide rail is 90°-100°; and
in the second state, the included angle between the support bar and the first guide rail is not greater than 45°.

4. The transport device according to claim 3, wherein
in the first state, the support bar is perpendicular to the first guide rail.

5. The transport device according to claim 2, wherein
the chain of the first conveying belt is circular and is capable of being driven to travel in a circular manner;
the first rail device has an upper support region and a lower return region, and the chain travels forwardly in the upper support region, and travels reversely in the lower return region such that the chain travels in a circular manner;
wherein the first conveying belt is configured such that the plurality of support bars in the upper support region are in the first state or in the second state; and the plurality of support bars in the lower return region are in the second state.

6. The transport device according to claim 5, wherein
each of the support bars comprises a bar portion and a rotating shaft, with the rotating shaft extending outwardly from a side of the chain, and the bar portion fitted over the rotating shaft; and the plurality of support bars are rotatably connected to the chain via the respective rotating shafts.

7. The transport device according to claim 6, wherein
the chain comprises a plurality of inner links, a plurality of outer links, and a plurality of pivots, the plurality of inner links and the plurality of outer links are alternately arranged in the length direction, the outer links are disposed on an outer side of adjacent two of the inner links, and the plurality of pivots pass through the corresponding outer links and inner links to hinge them;
wherein the plurality of support bars are connected to the corresponding outer links, the rotating shaft of each of the support bars is disposed between adjacent two of the pivots, and each of the support bars is configured to rotate between the adjacent two of the pivots.

8. The transport device according to claim 7, wherein
each of the support bars further comprises a limiting portion, the limiting portion being configured to prevent the support bar from continuing to rotate in the first direction after having reached the second state, and to prevent the support bar from continuing to rotate in the second direction after having reached the first state.

9. The transport device according to claim 8, wherein
the limiting portion comprises:
a notch, the notch being provided on the bar portion, wherein the shape and the dimension of the notch are configured such that the notch is capable of accommodating the pivot when the support bar is in the second state, and the pivot blocks the support bar from rotating in the first direction; and
a hook, the hook being connected to an end of the bar portion, wherein the shape and the dimension of the hook are configured such that the hook can hook the pivot when the support bar is in the first state, and the pivot blocks the support bar from rotating in the second direction.

10. The transport device according to claim 5, wherein
the first guide rail has an accommodating groove extending in the length direction, the accommodating groove comprises an upper chain accommodating groove and a lower chain accommodating groove, the upper chain accommodating groove is disposed in the upper support region and configured to accommodate and support the chain in the upper support region, and the lower chain accommodating groove is disposed in the lower return region and configured to accommodate and support the chain in the lower return region, wherein the plurality of support bars are connected to a side of the chain away from the accommodating groove;
wherein a bottom edge of the first guide rail has a flange protruding toward the chain, and the flange is configured to be capable of abutting against the support bars to keep the support bars in the second state.

11. The transport device according to claim 5, wherein
the first rail device has a rail entry;
wherein the first rail device further comprises an entry stop pin, the entry stop pin being disposed at the rail entry, wherein the entry stop pin is configured to be capable of extending toward the support bar to abut against the bottom of the support bar, so as to drive the support bar to rotate in the second direction, to switch the plurality of support bars located downstream of the entry stop pin from the second state to the first state.

12. The transport device according to claim 11, wherein
the first rail device further comprises:
a sensing device, the sensing device being configured to detect a state of the support bar; and
a driving device, the entry stop pin being connected to the driving device;
wherein the driving device is configured to, based on the detected state of the support bar, drive the entry stop pin to extend toward or retract from the support bar, so as to change the support bar from the second state to the first state, or keep the support bar in the second state.

13. The transport device according to claim 5, wherein
the first rail device has a rail exit;
wherein the first rail device further comprises an exit stop pin, the exit stop pin being disposed at the rail exit, wherein the exit stop pin is configured to be capable of extending toward the support bar to abut against the top of the support bar, so as to drive the support bar to rotate in the first direction, to switch the plurality of support bars located downstream of the exit stop pin from the first state to the second state.

14. A reflow oven, comprising:
a first rail device as described in any one of claims 1-13;
a second rail device comprising a second guide rail and a second conveying belt; and
a third rail device comprising a third guide rail and a third conveying belt;
wherein the second guide rail and the third guide rail extend in a length direction and are disposed at interval in a width direction, and the first guide rail is disposed between the second guide rail and the third guide rail in the width direction;
wherein when the support bars of the first rail device are in the first state, the tops of the support bars are capable of abutting against a lower surface of an element to be processed, and when the support bars are in the second state, the tops of the support bars are not in contact with the element to be processed;
and wherein the first conveying belt, the second conveying belt, and the third conveying belt travel synchronously, such that when the support bars are in the first state, the support bars of the first conveying belt, the second conveying belt, and the third conveying belt together carry the element to be processed to pass through the reflow oven.
